# FASCICULE DE BREVET EUROPEEN

(11) **EP 2 279 520 B1**
(45) Date de publication et mention de la délivrance du brevet: **26.09.2018**
(21) Numéro de dépôt: 09742293.5
(22) Date de dépôt: 09.04.2009
(51) Int. Cl.: H01L 21/336, H01L 29/78, H01L 21/8238, H01L 29/47, H01L 21/265, H01L 21/225, H01L 29/66

(54) **PROCÉDÉ DE FABRICATION DE TRANSISTORS MOSFET COMPLÉMENTAIRES DE TYPE P ET N**
VERFAHREN ZUR HERSTELLUNG KOMPLEMENTÄRER P- UND N-MOSFET-TRANSISTOREN
METHOD FOR MAKING COMPLEMENTARY P AND N MOSFET TRANSISTORS

(30) Priorité: 11.04.2008 FR 0852464
(43) Date de publication de la demande: 02.02.2011
(73) Titulaire: Centre National de la Recherche Scientifique (C.N.R.S.), 75016 Paris (FR)
(72) Inventeur: LARRIEU, Guilhem, F-59650 Villeneuve D'ascq (FR); DUBOIS, Emmanuel, F-59890 Quesnoy Sur Deule (FR)
(74) Mandataire: Lavoix
(86) Numéro de dépôt international: PCT/FR2009/050642
(87) Numéro de publication internationale: WO 2009/136095

(56) Documents cités:
- EP-A- 1 763 084
- GB-A- 2 124 428
- BERA L K ET AL: "Dopant-Segregated Ni-Silicide Schottky-Source/Drain CMOS on Strained-Si/SiGe Multiple Quantum-Well Channel on Bulk-Si" SOLID-STATE DEVICE RESEARCH CONFERENCE, 2006. ESSDERC 2006. PROCEEDING OF THE 36TH EUROPEAN, IEEE, PI, 1 septembre 2006 (2006-09-01), pages 290-293, XP031047050 ISBN: 978-1-4244-0301-1
- QIU Z J ET AL: "Role of Si implantation in control of underlap length in Schottky-barrier source/drain MOSFETs on ultrathin body SOI" ULTIMATE INTEGRATION OF SILICON, 2008. ULIS 2008. 9TH INTERNATIONAL CONFERENCE ON, IEEE, PISCATAWAY, NJ, USA, 12 mars 2008 (2008-03-12), pages 175-178, XP031256604 ISBN: 978-1-4244-1729-2
- ZHIJUN QIU ET AL: "A Comparative Study of Two Different Schemes to Dopant Segregation at NiSi/Si and PtSi/Si Interfaces for Schottky Barrier Height Lowering" IEEE TRANSACTIONS ON ELECTRON DEVICES, IEEE SERVICE CENTER, PISACATAWAY, NJ, US, vol. 54, no. 1, 1 janvier 2008 (2008-01-01), pages 396-403, XP011199367 ISSN: 0018-9383
- KINOSHITA A ET AL: "High-performance 50-nm-gate-length schottky-source/drain MOSFETs with dopant-segregation junctions" VLSI TECHNOLOGY, 2005. DIGEST OF TECHNICAL PAPERS. 2005 SYMPOSIUM ON KYOTO, JAPAN JUNE 14-16, 2005, PISCATAWAY, NJ, USA,IEEE, 14 juin 2005 (2005-06-14), pages 158-159, XP010818281 ISBN: 978-4-900784-00-0 & KINOSHITA A ET AL: "Solution for high-performance Schottky-source/drain MOSFETs: Schottky barrier height engineering with dopant segregation technique" VLSI TECHNOLOGY, 2004. DIGEST OF TECHNICAL PAPERS. 2004 SYMPOSIUM ON HONOLULU, HI, USA JUNE 15-17, 2004, PISCATAWAY, NJ, USA,IEEE, 15 juin 2004 (2004-06-15), pages 168-169, XP010732846 ISBN: 978-0-7803-8289-3
- MATSUMOTO S ET AL: "CMOS APPLICATION OF SCHOTTKY SOURCE/DRAIN SOI MOSFET WITH SHALLOW DOPED EXTENSION" JAPANESE JOURNAL OF APPLIED PHYSICS, JAPAN SOCIETY OF APPLIED PHYSICS, TOKYO.; JP, vol. 43, no. 4B, 1 avril 2004 (2004-04-01), pages 2170-2175, XP001227735 ISSN: 0021-4922
- "8.3.1 Aufbau der MOS-Transistoren und ihrer Isolation" In: D Widmann, H Mader, H Friedrich: "Technologie hochintegrierter Schaltungen, 2. Auflage", 1 January 1996 (1996-01-01), Springer Verlag Berlin Heidelberg New York ISBN: 3-540-59357-8 pages 275-283, * the whole document *
- WIDMANN D ET AL: "TECHNOLOGIE HOCHINTEGRIERTER SCHALTUNGEN, DETAILLIERTE PROZESSFOLGE AUSGEWÀHLTER GESAMTPROZESSE", 1 January 1996 (1996-01-01), TECHNOLOGIE HOCHINTEGRIERTER SCHALTUNGEN, SPRINGER VERLAG, DE, PAGE(S) 309 - 318, XP007914877, ISBN: 978-3-540-59357-7 * étapes 8-11; page 313, line 314; table 8.11 *

## Description

La présente invention concerne un procédé de fabrication de transistors MOSFET complémentaires de type p et n, à électrodes de source et de drain métalliques de type Schottky disposées sur un substrat semi-conducteur, les électrodes de source et de drain de chaque transistor étant reliées par un canal commandé par une électrode de grille.

Les documents BERA L K ET AL: "Dopant-Segregated Ni-Silicide Schottky-Source/Drain CMOS on Strained-Si/SiGe Multiple Quantum-Well Channel on Bulk-Si",SOLID-STATE DEVICE RESEARCH CONFERENCE, 2006. ESSDERC 2006. PROCEEDING OF THE 36TH EUROPEAN, IEEE, PI, 1 septembre 2006 (2006-09-01), pages 290-293, et QIU Z J ET AL: "Role of Si implantation in control of underlap length in Schottky-barrier source/drain MOSFETs on ultrathin body SOI",ULTIMATE INTEGRATION OF SILICON, 2008. ULIS 2008. 9TH INTERNATIONAL CONFERENCE ON, IEEE, PISCATAWAY, NJ, USA, 12 mars 2008 (2008-03-12), pages 175-178 décrivent un procédé de fabrication de transistors MOSFET, à électrodes de source et de drain métallique de type Schottky disposées sur un substrat semi-conducteur. La réalisation des électrodes de source et de drain pour chaque transistor est faite à partir d'un siliciure de nickel (Bera et al.) ou d'un siliciure de platine (Qiu et al.).

Le brevet US 7,052,945 B2 décrit un procédé de fabrication de transistors MOSFET complémentaires de type p et n, à électrodes de source et de drain métallique de type Schottky disposées sur un substrat semi-conducteur. La réalisation des électrodes de source et de drain pour chaque transistor de type p est faite à partir d'un siliciure de platine, d'un siliciure de palladium ou encore d'un siliciure d'iridium. La réalisation des électrodes de source et de drain pour chaque transistor de type n est faite à partir d'un siliciure à base de terres rares, telles que l'erbium. Les électrodes de source et de drain de chaque transistor sont reliées par un canal. Le canal de chaque transistor de type p est dopé avec un élément parmi le groupe consistant en : l'arsenic, le phosphore et l'antimoine. Le canal de chaque transistor de type n est dopé avec un élément parmi le groupe consistant en : le bore, l'indium et le gallium. Ce procédé permet d'obtenir pour chaque transistor de type p et n, un canal de longueur inférieure à 100 nanomètres, la longueur du canal étant la distance séparant les électrodes de source et de drain, reliées par ledit canal.

D'après la feuille de route ITRS 2005 (International Technology Roadmap for Semiconductors) éditée par l'Association des Industries du Semi-conducteur en 2005, les verrous pour le noeud technologique correspondant à une longueur de grille de 18 nm sont notamment les suivants :
- I : une forte solubilité du dopant et une très faible profondeur des extensions des électrodes de source et de drain à leur jonction avec le canal (xⱼ=5,1 nm),
- Il : un gradient de concentration abrupte aux jonctions entre le canal et les électrodes de source et de drain (inférieur à 1 nm/décade),
- III : une très faible épaisseur de siliciure (10 nm),
- IV : une consommation réduite du silicium lors de la formation de siliciure (inférieure à 8,4 nm),
- V : une faible résistance par carreau de siliciure (15,8 Ω/□ pour une épaisseur de siliciure de 10 nm),
- VI : une très faible résistance spécifique de contact de l'électrode de source et de l'électrode de drain à l'interface entre le siliciure et le canal (inférieure à 5,4x10⁻⁹ Ωxcm²), et
- VII : une faible résistance de contact total (de 60 à 80 Ωxµm).

Les transistors MOSFET complémentaires de type p et n décrits dans le brevet US 7,052,945 B2 permettent de parer aux verrous I et II, les jonctions entre les électrodes de source et de drain de type Schottky et le canal n'étant pas dopées, et de parer aux verrous III à V, l'épaisseur de siliciure n'étant pas limitée pour les électrodes de source et de drain de type Schottky.

Toutefois, les transistors MOSFET complémentaires de type p et n décrits dans le brevet US 7,052,945 B2 présentent des hauteurs de barrière Schottky voisines de 0,2 eV. Pour les électrodes de source et de drain du transistor de type p, réalisées à partir d'un siliciure de platine, la hauteur de barrière Schottky est sensiblement égale à 0,15 eV. Pour les électrodes de source et de drain du transistor de type n, réalisées à partir d'un siliciure à base de terres rares telles que l'ytterbium, respectivement l'erbium, la hauteur de barrière Schottky est sensiblement égale à 0,2 eV, respectivement 0,25 eV. Ces hauteurs de barrière Schottky relativement élevées ne permettent pas de remédier aux verrous technologiques VI et VII décrits ci-dessus. Elles ne permettent également pas d'obtenir des performances comparables aux performances obtenues avec des transistors MOSFET réalisés selon une approche conventionnelle, à savoir des transistors MOSFET avec des jonctions fortement dopées entre le canal et les électrodes de source et de drain. En effet, une hauteur de barrière élevée empêche d'obtenir une résistance spécifique de contact satisfaisante pour les électrodes de source et de drain.

En outre, le procédé de fabrication de transistors MOSFET complémentaires de type p et n, décrit dans le brevet US 7,052,945 B2 est relativement complexe, puisqu'il implique l'intégration de siliciure à base de terres rares pour la réalisation des électrodes de source et de drain des transistors de type n. L'intégration de terres rares est en effet très sensible à l'oxygène et doit être réalisée sous ultravide, ce terme étant utilisé pour désigner des vides très poussés.

L'invention a donc pour but de simplifier de manière importante la fabrication de transistors MOSFET complémentaires de type p et n, à électrodes de source et de drain de type Schottky, et de diminuer sensiblement la hauteur de barrière Schottky pour les électrodes de source et de drain desdits transistors MOSFET complémentaires, afin de minimiser les résistances spécifiques de contact des électrodes de source et de drain.

A cet effet, l'invention a pour objet un procédé de fabrication selon la revendication 1.

Suivant d'autres modes de réalisation, le procédé de fabrication comprend une ou plusieurs des caractéristiques selon les revendications dépendantes 2 à 9.

L'invention et ses avantages seront mieux compris à la lecture de la description qui va suivre, donnée uniquement à titre d'exemple et faite en référence aux dessins annexés, sur lesquels :
- la figure 1 est une représentation schématique et en coupe d'un dispositif électronique pour un substrat en silicium sur isolant, le siliciure n'ayant pas consommé tout le film de silicium, selon un premier mode de réalisation de l'invention,
- la figure 2 est une représentation schématique d'une étape de formation de l'électrode de grille, du procédé de fabrication selon le premier mode de réalisation de l'invention,
- la figure 3 est une représentation schématique d'une étape de formation du siliciure unique des électrodes de source et de drain, du procédé de fabrication selon le premier mode de réalisation de l'invention,
- la figure 4 est une représentation schématique d'une étape d'implantation d'impuretés du groupe II ou III dans le siliciure des électrodes de source et de drain d'un transistor de type p, du procédé de fabrication selon le premier mode de réalisation de l'invention,
- la figure 5 est une représentation schématique d'une étape d'implantation d'impuretés du groupe V ou VI dans le siliciure des électrodes de source et de drain d'un transistor de type n, du procédé de fabrication selon le premier mode de réalisation de l'invention,
- la figure 6 est une représentation schématique d'une étape de ségrégation des impuretés à l'interface entre le siliciure et le canal pour les transistors de type p et n, par l'intermédiaire d'une activation par recuit à basse température, du procédé de fabrication selon le premier mode de réalisation de l'invention,
- la figure 7 est un ensemble de courbes représentant l'évolution du courant de drain en fonction de la tension de polarisation de l'électrode de grille, pour des tensions de polarisation de l'électrode de drain variant en valeur absolue de 0,1V à 1,6V par pas de 0,25V, pour les transistors MOSFET complémentaires de type p et n, selon le premier mode de réalisation de l'invention,
- la figure 8 est un ensemble de courbes représentant l'évolution du courant de drain en fonction de la tension de polarisation de l'électrode de drain, pour une tension de polarisation de l'électrode de grille variant en valeur absolue de 0V à 2V par pas de 0,25V, pour les transistors MOSFET complémentaires de type p et n, selon le premier mode de réalisation de l'invention,
- la figure 9 est un diagramme de résultat représentant l'évolution de la hauteur de barrière Schottky pour les trous dans le transistor de type p après ségrégation d'impuretés de bore, en fonction de la température de recuit, selon le premier mode de réalisation de l'invention,
- la figure 10 est un diagramme de résultat représentant l'évolution de la hauteur de barrière Schottky pour les électrons dans le transistor de type n après ségrégation d'impuretés d'arsenic, en fonction de la température de recuit, selon le premier mode de réalisation de l'invention,
- la figure 11 est un diagramme de résultat représentant l'évolution de la hauteur de barrière Schottky pour les électrons dans le transistor de type n après ségrégation d'impuretés de soufre, en fonction de la température de recuit, selon un deuxième mode de réalisation de l'invention,
- la figure 12 est une représentation schématique et en coupe du dispositif électronique pour le substrat en silicium sur isolant, le siliciure ayant consommé tout le film de silicium, selon un troisième mode de réalisation de l'invention,
- la figure 13 est une représentation schématique de l'étape de formation du siliciure unique des électrodes de source et de drain, du procédé de fabrication selon le troisième mode de réalisation de l'invention, et
- la figure 14 est une représentation schématique et en coupe du dispositif électronique pour un substrat en silicium massif, selon un quatrième mode de réalisation de l'invention.

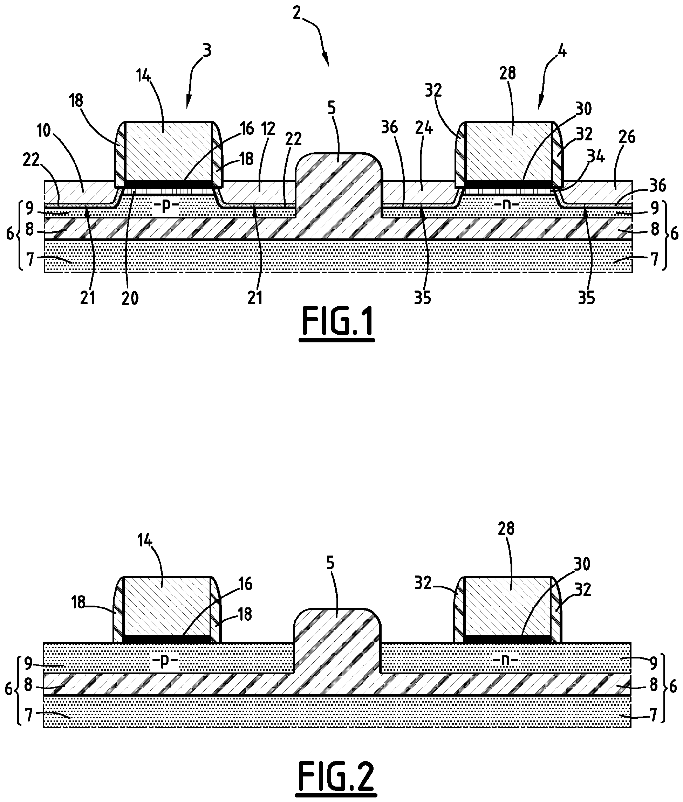

Sur la figure 1, un dispositif électronique 2 comprend un transistor MOSFET 3 de type p et un transistor MOSFET complémentaire 4 de type n. Le transistor MOSFET 3 de type p est séparé du transistor MOSFET 4 de type n par une zone d'isolation 5. Les transistors MOSFET 3,4 complémentaires sont réalisés sur un substrat 6 semi-conducteur. Dans le mode de réalisation décrit, le substrat 6 est un silicium sur isolant (SOI - de l'anglais Silicon On Insulator).

Le substrat SOI 6 est formé d'une plaquette de silicium 7 recouverte successivement d'une couche d'isolant 8 et d'une couche mince 9 de silicium. La couche d'isolant 8 est, par exemple, une couche de dioxyde de silicium (SiO₂). La couche mince 9, ou couche active, est d'épaisseur inférieure à 30 nm, de préférence comprise entre 2 et 15 nm. La couche active 9, totalement déplétée, est faiblement dopée, par exemple, de l'ordre de 5x10¹⁵ à 5x10¹⁷ cm⁻³. Le dopage est de type p pour le transistor MOSFET 3 de type p, et de type n pour le transistor MOSFET 4 de type n.

Le transistor MOSFET 3 de type p comprend une électrode de source 10, une électrode de drain 12 et une électrode de grille 14. L'électrode de grille 14 est isolée électriquement du reste de la structure par une couche d'isolant 16 de grille et par des entretoises isolantes 18 disposées de chaque côté de l'électrode de grille 14.

Les électrodes de source 10 et de drain 12 sont alignées sur l'électrode de grille 14. Les électrodes de source 10 et de drain 12 sont reliées par un canal 20. Pour chaque électrode de source 10 et de drain 12, des premières impuretés 21 sont ségrégées dans une zone 22 d'interface entre l'électrode correspondante 10, 12 et le canal 20 d'une part, et entre l'électrode correspondante 10, 12 et le substrat 6 d'autre part.

Le transistor MOSFET 4 de type n comprend une électrode de source 24, une électrode de drain 26 et une électrode de grille 28. L'électrode de grille 28 est isolée électriquement du reste de la structure par une couche d'isolant 30 de grille et par des entretoises isolantes 32 disposées de chaque côté de l'électrode de grille 28.

Les électrodes de source 24 et de drain 26 sont alignées sur l'électrode de grille 28. Les électrodes de source 24 et de drain 26 sont reliées par un canal 34. Pour chaque électrode de source 24 et de grille 26, des secondes impuretés 35 sont ségrégées dans une zone 36 d'interface, entre l'électrode correspondante 24, 26 et le canal 34 d'une part, et entre l'électrode correspondante 24, 26 et le substrat 6 d'autre part.

Les électrodes de source 10, 24 et de drain 12, 26 des transistors 3 de type p et 4 de type n sont des électrodes métalliques de type Schottky et sont formées à partir d'un siliciure unique. Le siliciure unique est, par exemple, un alliage de silicium et de platine (PtSi).

Chaque canal 20, 34 est, par exemple, un canal non contraint. Chaque canal 20, 34 est propre à être commandé par l'électrode de grille 14, 28 correspondante entre un mode bloqué et un mode passant. En mode bloqué, le courant circulant dans le canal 20, 34 entre l'électrode de source 10, 24 et l'électrode de drain 12, 26 est sensiblement nul. En mode passant, des porteurs de charge se déplacent sensiblement librement dans le canal 20, 34, le courant circulant de l'électrode de source 10, 24 vers l'électrode de drain 12, 26.

Les porteurs constituant le canal 20, 34 sont les porteurs majoritaires de la couche active 9, c'est-à-dire des électrons pour un dopage de type n et des trous pour un dopage de type p.

Chaque électrode de grille 14, 28 est réalisée en métal, par exemple en tungstène. Chaque couche isolante 16, 30 est réalisée en oxyde thermique, par exemple en dioxyde de silicium (SiO₂). Chaque entretoise isolante 18, 32 est réalisée en matériau diélectrique, par exemple en nitrure de silicium (SiN).

Les premières impuretés 21 ségrégées dans chaque zone d'interface 22 du transistor MOSFET de type p sont des éléments parmi les groupes II et III de la classification périodique des éléments. Dans le mode de réalisation décrit, les premières impuretés 21 sont du bore.

Les secondes impuretés 35 ségrégées dans chaque zone d'interface 36 du transistor MOSFET de type n sont des éléments parmi les groupes V et VI de la classification périodique des éléments. Dans le mode de réalisation décrit, les secondes impuretés 35 sont de l'arsenic.

La concentration des impuretés ségrégées 21, 35 est comprise entre 5x10⁷/cm³ et 5x10²¹/cm³, de préférence égale à 5x10²⁰/cm³.

Le procédé de fabrication du dispositif électronique 2 va maintenant être décrit à l'aide des figures 2 à 6.

Le procédé de fabrication débute par la réalisation du substrat SOI 6, par la formation de la zone d'isolation 5, et par le dopage de la couche active 9 selon le type p, n des transistors 3, 4.

Le procédé de fabrication se poursuit par la formation des couches d'isolation 16, 30, recouvertes des électrodes de grille 14, 28 correspondantes, comme représenté sur la figure 2. Les entretoises 18, 32 en diélectrique sont ensuite réalisées de chaque côté de l'électrode de grille 14, 28 correspondante, par un dépôt isotrope et une gravure plasma anisotrope.

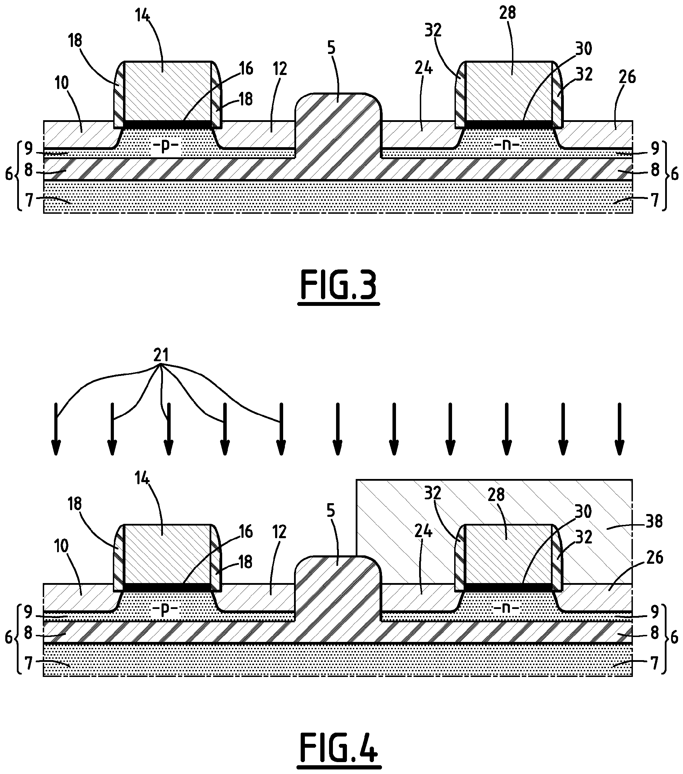

Le procédé de fabrication se poursuit par une étape de formation du siliciure unique, comme représenté sur la figure 3. Le siliciure unique est formé à base d'un alliage de silicium et de platine (PtSi) dans les zones des électrodes de source 10, 24 et de drain 12, 26. Dans le mode de réalisation décrit, la couche mince 9 de silicium du substrat 6 n'est pas entièrement consommée dans son épaisseur par le siliciure. Une fine couche de silicium demeure entre les zones des électrodes de source 10, 24 et de drain 12, 26 d'une part, et la couche d'isolant 8 d'autre part. Lors de la formation du siliciure, les zones des électrodes de source 10, 24 et de drain 12, 26 sont auto-alignées sur les électrodes de grille 14, 28.

Dans le mode de réalisation décrit, la ségrégation des impuretés 21, 35 à l'interface entre le siliciure des électrodes de source 10, 24 et de drain 12, 26, et le canal 20, 34 est effectuée par une implantation dans le siliciure (ITS - de l'anglais Implantation To Silicide), comme représenté sur les figures 4 à 6.

L'étape suivante du procédé de fabrication, représentée sur la figure 4, consiste à confiner par implantation ionique les premières impuretés 21 parmi les groupes II et III de la classification périodique des éléments, dans le siliciure de la zone des électrodes de source 10 et de drain 12. Dans le mode de réalisation décrit, les premières impuretés 21 implantées dans les zones 10, 12 sont des atomes de bore. Les zones des électrodes de source 24 et de drain 26, ainsi que l'électrode de grille 28 sont protégées par un masque 38, afin que les premières impuretés 21 de bore ne s'y implantent pas.

La densité du siliciure étant quatre fois plus grande que celle du silicium, les impuretés 21 de bore sont rapidement freinées dans la couche de siliciure des zones des électrodes de source 10 et de drain 12 lors de l'implantation ionique. L'électrode de grille 14 métallique fait écran lors de cette implantation, de sorte que les impuretés 21 de bore n'atteignent pas la portion de la couche active 9 située entre les zones des électrodes de source 10 et de drain 12. Après implantation, les impuretés 21 de bore sont donc majoritairement localisées dans les zones des électrodes de source 10 et de drain 12, par rapport à une très faible minorité ayant atteint la couche active 9.

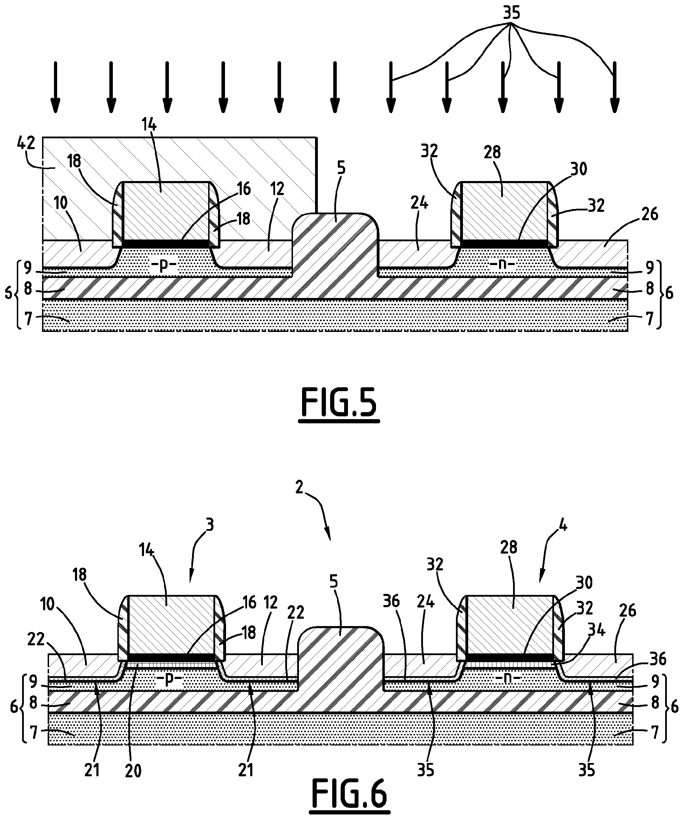

L'étape suivante du procédé de fabrication, représentée sur la figure 5, est une étape d'implantation des secondes impuretés 35 parmi les groupes V et VI de la classification périodique des éléments, dans le siliciure des zones des électrodes de source 24 et de drain 26. Dans le mode de réalisation décrit, les secondes impuretés 35 confinées dans les zones des électrodes de source 24 et de drain 26 sont des atomes d'arsenic. Les zones des électrodes de source 10 et de drain 12 ainsi que l'électrode de grille 14 sont protégées par un masque 42, afin que les secondes impuretés 35 d'arsenic ne s'y implantent pas. De manière identique à l'étape d'implantation des premières impuretés 21 décrite précédemment, et de par la densité du siliciure quatre fois plus grande que celle du silicium et le rôle d'écran de l'électrode de grille 28 métallique, les secondes impuretés 35 d'arsenic sont majoritairement localisées dans les zones des électrodes de source 24 et de drain 26 par rapport à une faible minorité ayant atteint la couche active 9.

La dernière étape, visible sur la figure 6, du procédé de fabrication du dispositif électronique 2 consiste en une étape de recuit unique à basse température, afin de faire ségréger les premières et secondes impuretés 21, 35 précédemment implantées, à l'interface entre le siliciure de chaque électrode de source 10, 24 et de drain 12, 26 et le canal correspondant 20, 34 d'une part, et entre le siliciure de chaque électrode de source 10, 24 et de drain 12, 26 et le substrat 6 d'autre part. La température de recuit est inférieure à 700° Celsius, de préférence égale à 600° Celsius.

Le principe de fonctionnement du dispositif électronique 2 est celui d'un transistor MOS à accumulation. Les porteurs constituant le canal 20 du transistor MOSFET de type p sont des trous et les porteurs constituant le canal 34 du transistor MOSFET de type n sont des électrons. La conduction de chaque canal 20, 34 est commandée par la tension de polarisation V_{GS} appliquée entre chaque électrode de grille 14, 28 et chaque électrode de source 10, 24 correspondante.

Par souci de simplification, la tension de polarisation V_{GS} appliquée entre chaque électrode de grille 14, 28 et chaque électrode de source 10, 24 correspondante est appelée tension de polarisation Vg de l'électrode de grille 14, 28. La tension de polarisation V_{DS} appliquée entre chaque électrode de drain 12, 26 et chaque électrode de source 10, 24 correspondante est appelée tension de polarisation Vd de l'électrode de drain 12, 26. Le courant I_{DS} circulant entre chaque électrode de drain 12, 26 et chaque électrode de source 10, 24 correspondante est appelé courant de drain Id.

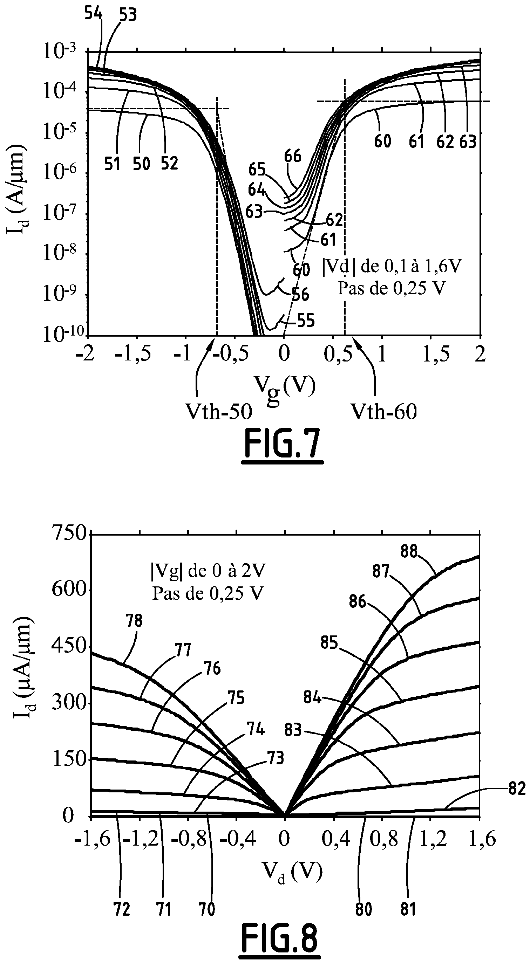

Les figures 7 et 8 illustrent des performances électriques obtenues pour des transistors MOSFET 3, 4, dont la longueur de l'électrode de grille 14, 28 en tungstène est égale à 70 nm et dont l'épaisseur de la couche isolante 16, 30 en oxyde thermique est égale à 2,4 nm, avec une température de recuit égale à 600° Celsius pour l'activation des impuretés 21, 35.

Sur la figure 7, les courbes 50 à 56 représentent l'évolution du courant de drain Id en fonction de la tension de polarisation Vg de l'électrode de grille 14, pour une tension de polarisation Vd de l'électrode de drain 12 variant de -0,1V à -1,6V par pas de -0,25V, pour le transistor MOSFET 3 de type p. Les courbes 50, 51, 52, 53, 54, 55 et 56 correspondent ainsi à une tension de polarisation Vd respectivement égale à -0,1V, -0,35V, -0,6V, - 0,85V, -1,1V, -1,35V et -1,6V. Les courbes 60 à 66 représentent l'évolution du courant de drain Id en fonction de la tension de polarisation Vg de l'électrode de grille 28, pour une tension de polarisation Vd de l'électrode de drain 26, variant de +0,1V à +1,6V par pas de +0,25V, pour le transistor MOSFET 4 de type n. Les courbes 60, 61, 62, 63, 64, 65 et 66 correspondent ainsi à une tension de polarisation Vd de l'électrode de drain 26 égale respectivement à +0,1V, +0,35V, +0,6V, +0,85V, +1,1V, +1,35V et +1,6V.

Sur la figure 8, les courbes 70 à 78 représentent l'évolution du courant de drain Id en fonction de la tension de polarisation Vd de l'électrode de drain 12, pour une tension de polarisation Vg de l'électrode de grille 14 variant de 0V à -2V par pas de -0,25V, pour le transistor MOSFET 3 de type p. Les courbes 70, 71, 72, 73, 74, 75, 76, 77 et 78 correspondent ainsi à une tension de polarisation Vg de l'électrode de grille 14 égale respectivement à 0V, -0,25V, -0,5V, -0,75V, -1V, -1,25V, -1,5V, -1,75V et -2V. Les courbes 80 à 88 représentent l'évolution du courant de drain Id en fonction de la tension de polarisation Vd de l'électrode de drain 26, pour une tension de polarisation Vg de l'électrode de grille 28 variant de 0V à +2V par pas de +0,25V, pour le transistor MOSFET 4 de type n. Les courbes 80, 81, 82, 83, 84, 85, 86, 87 et 88 correspondent ainsi à une tension de polarisation Vg de l'électrode de grille 28 égale respectivement à 0V, +0,25V, +0,5V, +0,75V, +1V, +1,25V, +1,5V, +1,75V et +2V.

En l'absence de toute tension de polarisation entre l'électrode de grille 14, 28 et l'électrode de source 10, 24, chaque transistor MOSFET 3, 4 est en mode bloqué. En effet, lorsque la tension de polarisation Vg de l'électrode de grille 14, 28 est voisine de 0V, une barrière additionnelle est créée par l'effet de champ développé par l'électrode de grille 14, 28 et empêche le courant Id de circuler entre l'électrode de source 10, 24 et l'électrode de drain 12, 26.

Pour le transistor 3 de type p, lorsque la tension de polarisation Vg de l'électrode de grille 14 est sensiblement égale à 0V, le courant de drain Id circulant dans le canal 20 est inférieur à 3x10⁻⁹A/µm, quelle que soit la valeur de la tension de polarisation Vd comprise entre -0,1V et -1,6V, comme le montre la figure 7. Pour le transistor 4 de type n, lorsque la tension de polarisation Vg de l'électrode de grille 28 est sensiblement égale à 0V, le courant de drain Id circulant dans le canal 34 est sensiblement égal à 1x10⁻⁸A/µm pour une tension de polarisation Vd égale à 0,1V, et croît jusqu'à une valeur d'environ 3x10⁻⁷A/µm pour une tension de polarisation Vd égale à +1,6V, comme le montre la figure 7.

Le transistor MOSFET 3 de type p est en mode passant pour une tension de polarisation Vg négative entre l'électrode de grille 14 et l'électrode de source 10. Le transistor MOSFET 4 de type n est en mode passant pour une tension de polarisation Vg positive entre l'électrode de grille 28 et l'électrode de source 24. Les tensions de polarisation Vg de chaque électrode de grille 14, 28 doivent en outre être supérieures en valeur absolue à une tension de seuil Vth, afin que chaque transistor 3, 4 soit en mode passant. Une couche de conduction de porteurs majoritaires présents dans le canal 20, 34 correspondant relie alors l'électrode de source 10, 24 à l'électrode de drain 12, 26, permettant au courant Id de circuler dans le canal 20, 34.

La tension de seuil Vth est principalement fonction du matériau de l'électrode de grille 14, 28.

Sur la figure 8, la tension de seuil Vth du transistor 3 de type p dépend de la tension de polarisation Vd de l'électrode de drain 12, et est sensiblement égale à la tension de polarisation Vg correspondant à la courbe 73, c'est-à-dire -0,75V. La tension de seuil Vth du transistor 4 de type n dépend de la tension de polarisation Vd de l'électrode de drain 26, et est sensiblement égale à la tension de polarisation Vg correspondant à la courbe 82, c'est-à-dire, +0,5V.

Sur la figure 7, les tensions de seuil Vth correspondent à l'abscisse du point d'intersection entre la pente en régime transitoire et l'asymptote en régime saturé de chaque courbe, comme indiqué pour les courbes 50 et 60. Graphiquement, la tension de seuil Vth_50 pour la courbe 50 est sensiblement égale à -0,75V et la tension de seuil Vth_60 pour la courbe 60 est voisine de +0,6V, ce qui correspond aux valeurs précédemment déduites des courbes de la figure 8. Il ressort également des figures 7 et 8, qu'une augmentation de la tension de polarisation Vd de l'électrode de drain 12, 26 entraîne une légère diminution de la tension de seuil Vth.

Sur la figure 7, le courant de drain Id circulant en régime saturé dans le canal 20 du transistor 3 de type p est sensiblement compris entre 3x10⁻⁵A/µm pour une tension de polarisation Vd de l'électrode de drain 12 égale à -0,1V (courbe 50), et 4,4x10⁻⁴A/µm pour une tension de polarisation Vd de l'électrode de drain 12 égale à -1,6V (courbe 56). Le courant de drain Id circulant en régime saturé dans le canal 34 du transistor 4 de type n varie de manière sensiblement identique au courant de drain Id en régime saturé du transistor 3 de type p, et est compris entre 4x10⁻⁵A/µm pour une tension de polarisation Vd de l'électrode de drain 26 égale à 0,1V (courbe 60), et 7,1x10⁻⁴A/µm pour une tension de polarisation Vd de l'électrode de drain 26 égale à +1,6V (courbe 66).

La pente sous le seuil pour le transistor 3 de type p est sensiblement égale à 12 décade/V, et la pente sous le seuil pour le transistor 4 de type n est sensiblement égale à 9 décade/V, comme le montre la figure 7.

En mode passant, lorsque la tension de polarisation Vg de l'électrode de grille 14, 28 est supérieure en valeur absolue à la tension de seuil Vth, la barrière électrostatique disparaît et la barrière Schottky restante est amincie de par la forte accumulation de porteurs dans le canal 20, 34. Une faible hauteur de barrière Schottky, idéalement voisine de 0eV, est alors prépondérante pour obtenir de bonnes performances électriques avec les transistors MOSFET 3, 4 à électrodes de source 10, 24 et de drain 12, 26 de type Schottky.

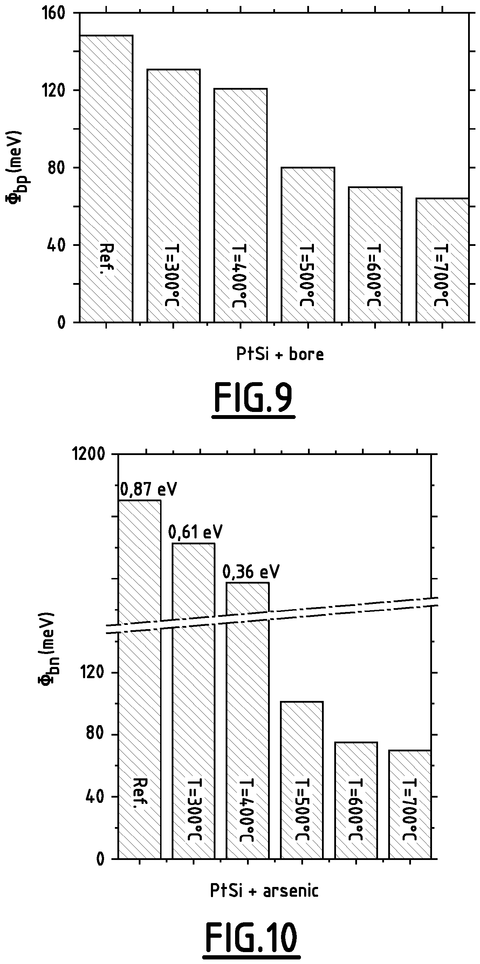

La figure 9 représente l'évolution de la hauteur de barrière Schottky pour le transistor MOSFET 3 de type p en fonction de la température de recuit. La hauteur de barrière Schottky pour les trous diminue nettement lorsque la température de recuit augmente jusqu'à une température de 500° Celsius. Pour une température de recuit au-delà de 500° Celsius, la hauteur de barrière Schottky pour les trous décroît légèrement de 0,08 eV pour une température de recuit égale à 500° Celsius, à 0,065 eV pour une température de recuit égale à 700° Celsius. Ainsi, la température de recuit sera de préférence égale à 500° Celsius.

Sur la figure 10, l'évolution de la hauteur de barrière Schottky pour le transistor MOSFET 4 de type n en fonction de la température de recuit, montre une très nette diminution de la hauteur de barrière Schottky pour les électrons lorsque la température de recuit augmente jusqu'à 600° Celsius. Pour une température de recuit au-delà de 600° Celsius, la hauteur de barrière Schottky pour les électrons décroît légèrement de 0,075 eV pour une température de recuit égale à 600° Celsius, à 0,07 eV pour une température de recuit égale à 700° Celsius. Ainsi, la température de recuit pour le transistor MOSFET 4 de type n, sera de préférence égale à 600° Celsius.

Ainsi, l'étape de ségrégation des impuretés est réalisée de manière unique pour les transistors MOSFET 3 de type p et 4 de type n à une basse température de recuit inférieure à 700°C, de préférence égale à 600° Celsius.

Avantageusement, le dispositif électronique 2 selon l'invention permet d'obtenir des performances électriques du meilleur niveau, comme décrit précédemment à l'aide des figures 7 et 8.

Avantageusement, le dispositif électronique 2 selon l'invention permet de diminuer de manière importante la barrière Schottky pour les électrodes de source 10, 24 et de drain 12, 26 des transistors MOSFET 3, 4 complémentaires.

Pour le transistor MOSFET 3 de type p, une hauteur de barrière Schottky inférieure ou égale à 0,08 eV est obtenue pour une température de recuit supérieure ou égale à 500° Celsius, ce qui est nettement inférieur aux valeurs typiques des hauteurs de barrières Schottky pour les transistors MOSFET de type p de l'état de la technique, à savoir environ 0,15 eV.

Pour le transistor MOSFET 4 de type n, une hauteur de barrière Schottky inférieure ou égale à 0,075 eV est obtenue pour une température de recuit supérieure ou égale à 600° Celsius, ce qui est nettement inférieur aux valeurs typiques des hauteurs de barrières Schottky pour les transistors MOSFET de type n de l'état de la technique, à savoir de 0,2 eV à 0,25 eV.

Avantageusement, l'étape de formation du siliciure est simplifiée de manière importante avec le procédé de fabrication selon l'invention. Le siliciure unique est, en effet, formé par l'intermédiaire d'une seule étape, alors que le procédé de fabrication de l'état de la technique utilisant deux siliciures différents implique plusieurs étapes pour la formation des siliciures, à savoir une étape de dépôt, une étape d'activation et une étape de retrait sélectif spécifique, pour chacun des deux types de siliciure, ce qui est nettement plus complexe que le procédé de fabrication selon l'invention.

Avantageusement, le procédé de fabrication selon l'invention ne nécessite pas l'intégration de terres rares dans le siliciure pour le transistor 4 de type n, ce qui simplifie également l'étape de formation du siliciure, ne nécessitant pas d'être réalisée sous ultravide.

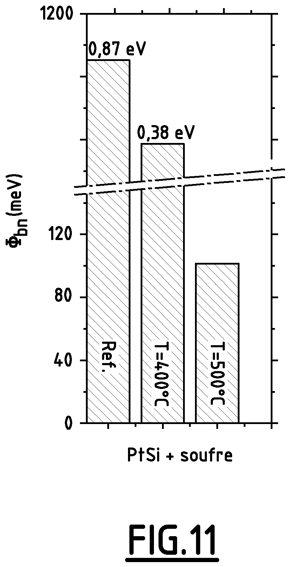

La figure 11 illustre un deuxième mode de réalisation, pour lequel les éléments analogues au mode de réalisation décrit précédemment sont repérés par des références identiques.

Selon le deuxième mode de réalisation, les secondes impuretés 35 confinées dans les zones des électrodes de source 24 et de drain 26 du transistor MOSFET 4 de type n sont des atomes de soufre. Le soufre est un double donneur et appartient au groupe VI de la classification périodique des éléments.

Sur la figure 11, l'évolution de la hauteur de barrière Schottky pour le transistor MOSFET 4 de type n en fonction de la température de recuit, montre une très nette diminution de la hauteur de barrière Schottky pour les électrons lorsque la température de recuit augmente jusqu'à 500° Celsius. Pour une température de recuit égale à 500° Celsius, la hauteur de barrière Schottky est sensiblement égale à 0,1 eV. Ainsi, la température de recuit pour le transistor MOSFET 4 de type n, sera de préférence égale à 500° Celsius.

Ainsi, l'étape de ségrégation des impuretés est réalisée de manière unique pour les transistors MOSFET 3 de type p et 4 de type n à une basse température de recuit inférieure à 700°C, de préférence égale à 500° Celsius selon le deuxième mode de réalisation.

Le fonctionnement de ce deuxième mode de réalisation est identique à celui du premier mode de réalisation et n'est donc pas décrit à nouveau.

Avantageusement, le dispositif électronique 2 selon l'invention permet de diminuer de manière importante la barrière Schottky pour les électrodes de source 24 et de drain 26 du transistor MOSFET 4 par ségrégation d'impuretés parmi le groupe VI de la classification périodique des éléments, constitué de doubles donneurs.

Avantageusement et de manière analogue, le dispositif électronique 2 selon l'invention permet de diminuer de manière importante la barrière Schottky pour les électrodes de source 10 et de drain 12 du transistor MOSFET 3 par ségrégation d'impuretés parmi le groupe II de la classification périodique des éléments, constitué de doubles accepteurs.

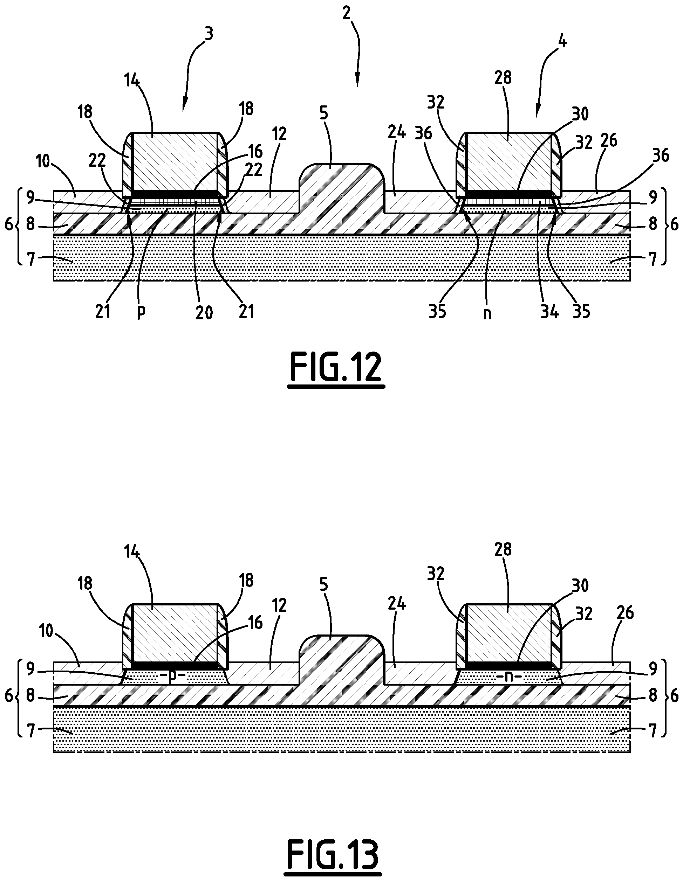

Les figures 12 et 13 illustrent un troisième mode de réalisation, pour lequel les éléments analogues au premier mode de réalisation décrit précédemment sont repérés par des références identiques.

Sur la figure 12, le siliciure unique des électrodes de source 10, 24 et de drain 12, 26 des transistors 3 de type p et 4 de type n du dispositif électronique 2, est en contact avec la couche isolante 8 du substrat SOI 6.

Le procédé de fabrication diffère en effet du procédé de fabrication décrit pour le premier mode de réalisation par l'étape de formation du siliciure représentée sur la figure 13. Lors de l'étape de formation du siliciure unique pour ce troisième mode de réalisation, le siliciure consomme toute la couche active 9 de silicium située dans les zones des électrodes de source 10, 24 et de drain 12, 26. Après formation du siliciure unique, les électrodes de source 10, 24 et de drain 12, 26 sont ainsi en contact avec la couche isolante 8 en dioxyde de silicium du substrat SOI 6. La couche active 9 faiblement dopée reste présente dans une zone située sous l'électrode de grille 14, 28.

Le fonctionnement de ce troisième mode de réalisation est identique à celui du premier mode de réalisation et n'est donc pas décrit à nouveau.

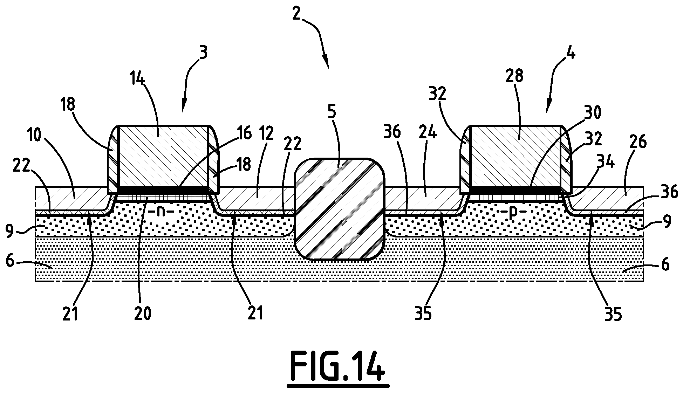

La figure 14 illustre un quatrième mode de réalisation, pour lequel les éléments analogues au premier mode de réalisation décrit précédemment sont repérés par des références identiques.

Le transistor MOSFET 3 de type p et le transistor MOSFET 4 de type n du dispositif électronique 2 sont réalisés sur un substrat 6 en silicium massif. Chaque transistor MOSFET 3, 4 comporte, dans la partie supérieure du substrat 6 en silicium massif, une couche active 9 faiblement dopée également appelée puits, la concentration du dopage étant de l'ordre de 10¹⁵ à 10¹⁷ cm⁻³. Le dopage du puits 9 est de type n pour le transistor MOSFET 3 de type p, et le dopage du puits 9 est de type p pour le transistor MOSFET 4 de type n.

La profondeur de la zone d'isolation 5 est propre à empêcher toute migration de trous du puits 9 du transistor MOSFET 3 de type p vers le transistor MOSFET 4 de type n, et inversement toute migration d'électrons du puits 9 du transistor MOSFET 4 de type n vers le transistor MOSFET 3 de type p.

Le fonctionnement de ce quatrième mode de réalisation est identique au fonctionnement connu d'un transistor MOS à déplétion, également appelé transistor MOS à appauvrissement.

Selon un autre mode de réalisation, le substrat 6 est un substrat en silicium sur rien.

Selon un autre mode de réalisation, le substrat 6 est un substrat à base de germanium.

Selon un autre mode de réalisation, l'électrode de grille 14 est réalisée en polysilicium.

Selon un autre mode de réalisation, les couches d'isolation 16, 30 sont réalisées dans un matériau diélectrique à haute constante diélectrique (HK), tel que l'oxyde d'hafnium (HfO₂), le silicate d'oxyde d'hafnium (HfOSi), ou encore l'aluminate de lanthane (LaAlO₃).

Selon un autre mode de réalisation, la ségrégation des impuretés 21, 35 à l'interface entre le siliciure des électrodes de source 10, 24 et de drain 12, 26, et le canal 20, 34 est effectuée par une implantation dans le métal (ITM - de l'anglais Implantation To Metal), pour tout type de substrat.

L'implantation dans le métal consiste à confiner les impuretés 21, 35 dans le métal par implantation ionique, puis à faire ségréger les impuretés 21, 35 à l'interface entre le siliciure et le canal 20, 34 correspondant par l'intermédiaire d'une activation réalisée lors de l'étape de formation du siliciure.

Selon un autre mode de réalisation, la ségrégation des impuretés 21, 35 entre le siliciure des électrodes de source 10, 24 et de drain 12, 26, et le canal 20, 34 est effectuée par une implantation avant le siliciure (IBS - de l'anglais Implantation Before Silicide), pour tout type de substrat.

L'implantation avant le siliciure consiste à implanter les impuretés 21, 35 sur une faible épaisseur du silicium du substrat 6, localisée à proximité de la face supérieure du substrat 6, puis à former le siliciure unique des électrodes de source 10, 24 et de drain 12, 26, afin de consommer la totalité de l'épaisseur de la couche implantée. Les impuretés 21, 35 ségrégent à l'interface entre le siliciure et le canal 20, 34 lors de l'étape de formation du siliciure.

Selon un autre mode de réalisation, le siliciure unique est un alliage comprenant du silicium et du platine.

Selon un autre mode de réalisation, le siliciure unique est un alliage comprenant du nickel et du silicium.

Selon un autre mode de réalisation, des premières impuretés 21 d'aluminium, de gallium, ou encore d'indium sont ségrégées à l'interface entre le siliciure et le canal 20 pour la réalisation des électrodes de source 10 et de drain 12 du transistor MOSFET 3 de type p.

Selon un autre mode de réalisation, des premières impuretés 21 de béryllium, de magnésium, de calcium, de strontium, ou encore de baryum sont ségrégées à l'interface entre le siliciure et le canal 20 pour la réalisation des électrodes de source 10 et de drain 12 du transistor MOSFET 3 du type p.

Selon un autre mode de réalisation, des secondes impuretés 35 de phosphore, ou encore d'antimoine sont ségrégées à l'interface entre le siliciure et le canal 34 pour la réalisation des électrodes de source 24 et de drain 26 du transistor MOSFET 4 de type n.

Selon un autre mode de réalisation, des secondes impuretés 35 de sélénium, ou encore de tellure sont ségrégées à l'interface entre le siliciure et le canal 34, pour la réalisation des électrodes de source 24 et de drain 26 du transistor MOSFET 4 de type n.

Selon un autre de réalisation, les canaux 20, 34 sont des canaux contraints réalisés par utilisation d'un substrat en silicium contraint sur isolant (sSOI - de l'anglais strain Silicon On Insulator).

Selon un autre mode de réalisation, les canaux 20, 34 sont des canaux contraints réalisés par épitaxie sélective des zones des électrodes de source 10, 24 et de drain 12, 26.

Selon un autre mode de réalisation, les canaux 20, 34 sont des canaux contraints réalisés avec une couche de matériau diélectrique contrainte, par exemple une couche de nitrure contrainte, ou encore une couche d'oxyde contrainte.

Selon un autre mode de réalisation, les canaux 20, 34 sont des canaux en ailettes.

Selon un autre mode de réalisation, les canaux 20, 34 sont des canaux à base de nanofils.

On conçoit ainsi que le dispositif électronique selon l'invention permet de minimiser les résistances spécifiques de contact des électrodes de source et de drain de chaque transistor MOSFET de type p et n, de par la diminution importante de la hauteur de barrière Schottky pour lesdites électrodes de source et de drain de chaque transistor.

On conçoit également que le procédé de fabrication du dispositif électronique selon l'invention est simplifié de manière notable, de par l'utilisation d'un siliciure unique pour la réalisation des électrodes de source et de drain des transistors MOSFET complémentaires. L'utilisation d'un siliciure sans élément du groupe des terres rares participe aussi à la simplification du procédé de fabrication selon l'invention.

## Revendications

1. Procédé de fabrication de transistors MOSFET (3, 4) complémentaires de types p et n, à électrodes de source (10, 24) et de drain (12, 26) métalliques de type Schottky disposées sur un substrat (6) semi-conducteur, les électrodes de source (10, 24) et de drain (12, 26) de chaque transistor (3, 4) étant reliées par un canal (20, 34) commandé par une électrode de grille (14, 28),
ledit procédé comprenant :
- la sélection dudit substrat (6) parmi le groupe consistant en : un silicium massif, un silicium sur isolant, et un silicium sur rien,
- la réalisation des électrodes de source (10, 24) et de drain (12, 26) à partir d'un siliciure unique pour les deux types p et n de transistors (3, 4), disposé sur le substrat (6) semi-conducteur,
- la ségrégation de premières impuretés (21), formées d'un élément parmi les groupes II et III de la classification périodique des éléments, à l'interface (22) entre le siliciure et le canal (20) du transistor (3) de type p, pour la réalisation des électrodes de source (10) et de drain (12) du transistor (3) de type p, le transistor (4) complémentaire de type n étant masqué,
- la ségrégation de secondes impuretés (35), formées d'un élément parmi les groupes V et VI de la classification périodique des éléments, à l'interface (36) entre le siliciure et le canal (34) du transistor (4) de type n, pour la réalisation des électrodes de source (24) et de drain (26) du transistor (4) de type n, le transistor (3) complémentaire de type p étant masqué,
la ségrégation des premières et secondes impuretés (21, 35) étant effectuée par une implantation parmi le groupe consistant en : l'implantation dans le métal et l'implantation avant le siliciure,
les premières et secondes impuretés (21, 35) étant ségrégées à l'interface (22, 36) entre le siliciure et le canal (20, 34) lors de l'étape de formation du siliciure unique.

2. Procédé selon la revendication 1, **caractérisé en ce que** le siliciure unique est un alliage comprenant du silicium et du platine.

3. Procédé selon la revendication 1, **caractérisé en ce que** le siliciure unique est un alliage comprenant du nickel et du silicium.

4. Procédé selon l'une quelconque des revendications précédentes, **caractérisé en ce qu'**il comprend la sélection d'une technologie de réalisation dudit canal (20, 34) parmi le groupe consistant en : un canal non contraint, un canal contraint par utilisation d'un substrat en silicium contraint sur isolant, un canal contraint par épitaxie sélective de zones source et drain, un canal avec une couche de matériau diélectrique contrainte, un canal en ailettes, et un canal à base de nanofils.

5. Procédé selon l'une quelconque des revendications précédentes, **caractérisé en ce qu'**il comprend pour les transistors (3) de type p, la sélection des premières impuretés (21) parmi la liste d'éléments du groupe II consistant en : le béryllium, le magnésium, le calcium, le strontium et le baryum.

6. Procédé selon l'une quelconque des revendications 1 à 4 **caractérisé en ce qu'**il comprend, pour les transistors (3) de type p, la sélection des premières impuretés (21) parmi la liste d'éléments du groupe III consistant en : le bore, l'aluminium, le gallium et l'indium.

7. Procédé selon l'une quelconque des revendications précédentes, **caractérisé en ce qu'**il comprend, pour les transistors (4) de type n, la sélection des secondes impuretés (35) parmi la liste d'éléments du groupe V consistant en : le phosphore, l'arsenic et l'antimoine.

8. Procédé selon l'une quelconque des revendications 1 à 6, **caractérisé en ce qu'**il comprend, pour les transistors (4) de type n, la sélection des secondes impuretés (35) parmi la liste d'éléments du groupe VI consistant en : le soufre, le sélénium et le tellure.

9. Procédé selon l'une quelconque des revendications précédentes, **caractérisé en ce que** la concentration des premières et secondes impuretés (21, 35) ségrégées est comprise entre 5 x 10⁷/cm³ et 5 x 10²¹/cm³.

## Patentansprüche

1. Verfahren zum Herstellen von komplementären MOSFET-Transistoren (3, 4) der Typen p und n mit metallischen Source-Elektroden (10, 24) und Drain-Elektroden (12, 26) des Schottky-Typs, die auf einem Halbleitersubstrat (6) angeordnet sind, wobei die Source-Elektroden (10, 24) und die Drain-Elektroden (12, 26) jedes Transistors (3, 4) durch einen Kanal (20, 34) verbunden sind, der durch eine Gate-Elektrode (14, 28) gesteuert wird,
wobei das Verfahren aufweist:
- Auswählen des Substrats (6) aus der Gruppe bestehend aus einem massiven Silicium, einem Silicium auf einem Isolator und einem Silicium auf nichts,
- Realisieren der Source-Elektroden (10, 24) und der Drain-Elektroden (12, 26) aus einem einzigen Silicid für die beiden Transistortypen p und n (3, 4), das auf dem Halbleitersubstrat (6) angeordnet ist,
- Segregieren von ersten Verunreinigungen (21), die aus einem Element aus den Gruppen II und III des Periodensystems der Elemente gebildet werden, an der Schnittstelle (22) zwischen dem Silicid und dem Kanal (20) des Transistors (3) des Typs p für das Realisieren der Source-Elektrode (10) und der Drain-Elektrode (12) des Transistors (3) des Typs p, wobei der komplementäre Transistor (4) des Typs n maskiert wird,
- Segregieren von zweiten Verunreinigungen (35), die aus einem Element aus den Gruppen V und VI des Periodensystems der Elemente gebildet werden, an der Schnittstelle (36) zwischen dem Silicid und dem Kanal (34) des Transistors (4) des Typs n für das Realisieren der Source-Elektrode (24) und der Drain-Elektrode (26) des Transistors (4) des Typs n, wobei der komplementäre Transistor (3) des Typs p maskiert wird,
wobei das Segregieren der ersten und der zweiten Verunreinigungen (21, 35) durch eine Implantation aus der Gruppe durchgeführt wird, die aus der Implantation im Metall und der Implantation vor dem Silicid besteht,
wobei die ersten und die zweiten Verunreinigungen (21, 35) an der Schnittstelle (22, 36) zwischen dem Silicid und dem Kanal (20, 34) während des Schrittes des Ausbildens des einzigen Silicids segregiert werden.

2. Verfahren gemäß Anspruch 1, **dadurch gekennzeichnet, dass** das einzige Silicid eine Legierung ist, die Silicium und Platin aufweist.

3. Verfahren gemäß Anspruch 1, **dadurch gekennzeichnet, dass** das einzige Silicid eine Legierung ist, die Nickel und Silicium aufweist.

4. Verfahren gemäß irgendeinem der vorhergehenden Ansprüche, **dadurch gekennzeichnet, dass** es das Auswählen einer Technologie zum Realisieren des Kanals (20, 34) aus der Gruppe aufweist, die aus einem nicht-beschränkten Kanal, einem durch die Verwendung eines beschränkten Siliciumsubstrats auf einem Isolator beschränkten Kanal, einem durch selektive Epitaxie von Source- und Drain-Zonen beschränkten Kanal, einem Kanal mit einer beschränkten dielektrischen Materialschicht, einem Kanal mit Lamellen und einem Kanal auf Nanofaserbasis besteht.

5. Verfahren gemäß irgendeinem der vorhergehenden Ansprüche, **dadurch gekennzeichnet, dass** es für die Transistoren (3) des Typs p das Auswählen der ersten Verunreinigungen (21) aus der Liste von Elementen der Gruppe II bestehend aus Beryllium, Magnesium, Calcium, Strontium und Barium aufweist.

6. Verfahren gemäß irgendeinem der Ansprüche 1 bis 4, **dadurch gekennzeichnet, dass** es für die Transistoren (3) des Typs p das Auswählen der ersten Verunreinigungen (21) aus der Liste von Elementen der Gruppe III bestehend aus Bor, Aluminium, Gallium und Indium aufweist.

7. Verfahren gemäß irgendeinem der vorhergehenden Ansprüche, **dadurch gekennzeichnet, dass** es für die Transistoren (4) des Typs n das Auswählen der zweiten Verunreinigungen (35) aus der Liste von Elementen der Gruppe V bestehend aus Phosphor, Arsen und Antimon aufweist.

8. Verfahren gemäß irgendeinem der Ansprüche 1 bis 6, **dadurch gekennzeichnet, dass** es für die Transistoren (4) des Typs n das Auswählen der zweiten Verunreinigungen (35) aus der Liste von Elementen der Gruppe VI bestehend aus Schwefel, Selen und Tellur aufweist.

9. Verfahren gemäß irgendeinem der vorhergehenden Ansprüche, **dadurch gekennzeichnet, dass** die Konzentration der ersten und der zweiten segregierten Verunreinigungen (21, 35) zwischen 5 x 10⁷/cm³ und 5 x 10²¹/cm³ liegt.

## Claims

1. A method for making complementary p and n MOSFET transistors (3, 4), with metal Schottky source (10, 24) and drain (12, 26) electrodes arranged on a semiconductor substrate (6), the source (10, 24) and drain (12, 26) electrodes of each transistor (3, 4) being connected by a channel (20, 34) controlled by a gate electrode (14, 28),
said method comprising:
- selecting said substrate (6) from the group consisting of: solid silicon, silicon on insulator, and silicon on nothing,
- making the source (10, 24) and drain (12, 26) electrodes from a single silicide for both the p and n transistors (3, 4), arranged on the semiconductor substrate (6),
- segregating first impurities (21) from groups II and III of the periodic table, at the interface (22) between the silicide and the channel (20) of the p transistor (3), to make source (10) and drain (12) electrodes of the p transistor (3), the complementary n transistor (4) being masked,
- segregating second impurities (35) from groups V and VI of the periodic table, at the interface (36) between the silicide and the channel (34) of the n transistor (4), to make source (24) and drain (26) electrodes of the n transistor (4), the complementary p transistor (3) being masked,
the segregation of the first and second impurities (21, 35) being done by an implantation from the group consisting of: implantation in metal and implantation before silicide,
the first and second impurities (21, 35) being segregated at the interface (22, 36) between the silicide and the channel (20, 34) during the step of forming the single silicide.

2. The method according to claim 1, **characterized in that** the single silicide is an alloy comprising silicon and platinum.

3. The method according to claim 1, **characterized in that** the single silicide is an alloy comprising nickel and silicon.

4. The method according to any one of the preceding claims, **characterized in that** it comprises the selection of a technology for making said channel (20, 34) from the group consisting of: a non-strained channel, a channel strained by the use of a strained silicon on insulator substrate, a channel strained by selective epitaxy of source and drain zones, a channel with a strained layer of dielectric material, a flanged channel and a nanowire-based channel.

5. The method according to any one of the preceding claims, **characterized in that** it comprises, for the p transistors (3), the selection of the first impurities (21) from the list of elements of group II consisting of: beryllium, magnesium, calcium, strontium and barium.

6. The method according to any one of claims 1 to 4, **characterized in that** it comprises, for the p transistors (3), the selection of the first impurities (21) from the list of elements of group III consisting of: boron, aluminum, gallium and indium.

7. The method according to any one of the preceding claims, **characterized in that** it comprises, for the n transistors (4), the selection of the second impurities (35) from the list of elements of group V consisting of: phosphorous, arsenic and antimony.

8. The method according to any one of claims 1 to 6, **characterized in that** it comprises, for the n transistors (4), selecting second impurities (35) from the list of elements of group VI consisting of: sulfur, selenium and tellurium.

9. The method according to any one of the preceding claims, **characterized in that** the concentration of the segregated first and second impurities (21, 35) is between 5 x 10⁷/cm³ and 5 x 10²¹/cm³.
